# EUROPÄISCHE PATENTANMELDUNG

(11) **EP 1 076 362 A2**
(43) Veröffentlichungstag der Anmeldung: **14.02.2001**
(21) Anmeldenummer: 00117082.8
(22) Anmeldetag: 09.08.2000
(51) Int. Cl.: H01L 27/02, H01L 29/78

(54) **Halbleiterschaltung**

(30) Priorität: 13.08.1999 DE 19938403
(71) Anmelder: Micronas GmbH, 79108 Freiburg (DE)
(72) Erfinder: Motz, Mario, Dipl.-Ing., 9241 Wernberg (AT); Besemann, Michael, Dipk.-Ing., 79108 Freiburg (DE)
(74) Vertreter: Goy, Wolfgang, Dipl.-Phys.

(57) **Zusammenfassung**

Um bei einer Schaltung mit einer Betriebsspannungsleitung 3 und einer Masse-Anschlußleitung 5 einen Schutz bei Verpolung zu gewährleisten, ist in die Masse-Anschlußleitung 5 ein Transistor 6 eingefügt, welcher im Normalbetrieb, bei Anliegen der Betriebsspannung Vdd an der Betriebsspannungsleitung 3, in einen leitenden Zustand und in einem Verpolungsfall, bei Anliegen der Betriebsspannung an der Masse-Anschlußleitung 5, in einen nichtleitenden Zustand geschaltet ist, wobei der Tranistor 6 im Verpolungsfall gegebenenfalls auch zum Sperren einer hohen Betriebsspannung Vdd geeignet ist.

## Beschreibung

Die Erfindung betrifft eine Schaltung gemäß dem Oberbegriff des Anspruchs 1.

Eine derartige Schaltung ist beispielsweise in integrierten Schaltkreisen vorgesehen, wie sie beispielsweise als Sensoren in der Automobilbranche eingesetzt werden, vergleiche hierzu die eigene Patentanmeldung EP 0 648 019 A2 (internes Aktenzeichen: C-1463EP). Die Bordspannungen sind im Kraftfahrzeugbereich in der Regel durch die 12 Volt Batteriespannung vorgegeben. Im realen Betrieb können sich jedoch erhebliche Abweichungen nach oben und unten von diesem Wert ergeben. Die zu beachtenden Betriebsspannungen können zwischen 5 Volt bis 24 Volt oder sogar noch außerhalb dieser Grenzen liegen. Durch externe und/oder interne Schutzmaßnahmen, wie z.B. interne Spannungsstabilisierungseinrichtungen und eine erhöhte Spannungsfestigkeit der Schaltung durch eine angepaßte Schaltungsauslegung sowie Verwendung von internen Überspannungsschutzeinrichtungen, können diese hohen Betriebsspannungen zugelassen werden. Werden jedoch insbesondere bei hohen Betriebsspannungen die Anschlüsse für die Betriebsspannung und für die Masse vertauscht, so daß an der Betriebsspannungsleitung Masse und an der Masse-Anschlußleitung die Betriebsspannung anliegt, so kann die Schaltung ohne weitere Schutzmaßnahmen zerstört oder geschädigt werden, beispielsweise infolge einer thermischen Überlastung durch zu große Ströme im Durchbruchsfall oder eine Schädigung von Transistoren durch zu große Streßspannungen. Die aus EP 0 648 019 A2 bekannte Schaltung weist einen gewissen Schutz gegen eine solche Verpolung auf, indem der Verplolungsstrom durch einen internen oder externen Widerstand begrenzt wird.

Der Erfindung liegt die **Aufgabe** zugrunde, die Schutzeinrichtung der eingangs genannten Art derart weiterzuentwickeln, daß auch bei denjenigen Schaltungen ein Schutz bei Verpolung möglich ist, bei denen die Anwendung der bekannten obigen Schutzeinrichtung nicht möglich ist; ferner soll die Weiterentwicklung zusammen mit der eigentlichen Schaltung monolithisch integrierbar sein, so daß externe Verpolschutzeinrichtungen entfallen und auch Überspannungen im Verpolungsfall für die gesamte Schaltungsanordnung unschädlich sind.

Als technische **Lösung** dieser Aufgabe wird mit der Erfindung vorgeschlagen, daß die Schaltung gemäß dem Oberbegriff des Anspruchs 1 entsprechend dem kennzeichnenden Teil dieses Anspruchs 1 ausgebildet ist.

Die Grundidee der Erfindung besteht darin, zwischen dem inneren Masse-Anschluß (gemeint ist der übliche Masse-Anschluß auf dem Chip der monolithisch integrierten Schaltung) und dem Anschluß für die externe Masse einen Transistor auf dem Chip zusätzlich einzufügen. Dieser soll im Normalbetrieb leitend und im Verpolungsfall, nämlich bei Anliegen der Betriebsspannung an der Masse-Anschlußleitung und der Masse an der Betriebsspannungsleitung, nicht leitend sein. Somit kann die falsch angelegte Betriebsspannung nicht an der eigentlichen Schaltung anliegen, so daß diese nun geschützt ist und nicht zerstört wird. Damit im Verpolungsfall der Transistor selbst durch hohe Spannungen nicht zerstört wird, ist er als Hochspannungstransistor ausgeführt. Ein wesentlicher Vorteil dieser Schutzeinrichtung ist, daß im Verpolungsfall kein Strom fließt.

Zur Erreichung des leitenden Zustandes und des nichtleitenden Zustandes des Tranistors sieht eine Weiterbildung der Erfindung vor, daß seine Steuer-Elektrode mit der einen Betriebsspannungsleitung verkoppelt oder direkt verbunden ist. Hierdurch steuert der Spannungswert auf der Betriebsspannungsleitung unmittelbar die Wirkungsweise des Transistors.

Eine bevorzugte Ausführungsform der Erfindung für einen Standard-CMOS-Herstellungsprozess sieht vor, daß der für den Verpolungsschutz dienende Transistor als MOS-Transistor mit einem n-leitenden Kanal ausgebildet ist. Seine Source- und Drain-Elektroden sind wie üblich in relativ hoch dotierte Gebiete eingebettet, die vom entgegengesetzten Leitfähigkeitstyp wie das p-leitende Substrat sind. Der im Normalbetrieb, also ohne Verpolung, als Source-Gebiet dienende Transistorbereich ist seinerseits in eine relativ schwach dotierte n-Wanne eingebettet, die seitlich und unterhalb des Source-Gebietes angeordnet und vom gleichen Leitfähigkeitstyp wie der Transistor und vom entgegengesetzten Leitfähigkeitstyp wie das Substrat ist. Im Normalbetrieb, also ohne Verpolung, bildet sich ein leitender Kanal zwischen Source und Drain aus. Der Transistor ist somit leitend und bei geeigneter großer Auslegung fällt nahezu keine Spannung über seine Drain-Source-Strecke ab. Im Verpolungsfall wird Source zu Drain und Drain zu Source und der Transistor wird über seine Steuerelektrode gesperrt, wodurch ein leitender Kanal nicht mehr vorliegt. Die anliegende Betriebsspannung fällt dabei im wesentlichen über der schwach dotierten n-Wanne ab, so daß am empfindlichen Gate-Oxid keine kritische Feldstärke, die zur Schädigung des Transistors führt, auftreten kann.

Bei einer Weiterbildung der Erfindung ist der Transistor ein n-Kanal-MOSFET vom Enhancement-Typ (Anreicherungstyp), wobei vorteilhafterweise die Wanne zur Einbettung des Source-Gebietes - Source ist hier auf den unverpolten normalen Betriebsfall bezogen - relativ schwach, z.B. n--dotiert; ist. Es ist auch denkbar, einen weiteren Transisor zum Schutz gegen Verpolung nicht nur in die Masse-Anschlußleitung sondern zusätzlich auch in die Betnebsspannungsleitung einzufügen. Dieser Transistor ist dann vom anderen Leitungstyp, also beispielsweise ein p-Kanal-MOSFET.

Die Signalausgänge der inneren Schaltung mit den zugehörigen Tranistoren sind ebenfalls durch den oben als ein Ausführungsbeispiel angegebenen Transistor gegen eine Verpolung der Betriebsspannung geschützt. Zum Schutz der innerem Schaltung bei Verpolung der Versorgungsanschlüsse ist als ein weiteres Ausführungsbeispiel auch ein mitintegrierbarer DMOS-Transistor (=Diffused MOS) geeignet, der in der Regel auch die gewünschte Hochspannungsverträglichkeit aufweist.

Die Erfindung wird nachstehend anhand der Zeichnung näher erläutert. Hierbei stellen dar:
- Fig. 1: die erfindungsgemäße Schaltung;
- Fig. 2: einen Querschnitt durch den in der Schaltung nach Fig. 1 verwendeten Transistor.

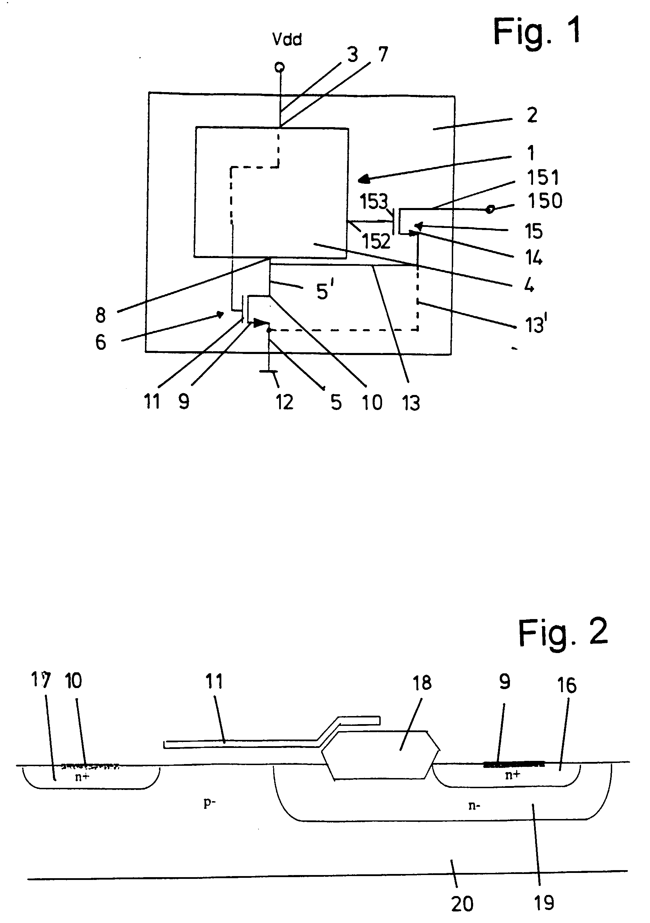

Die in Fig. 1 dargestellte erfindungsgemäße Schaltung 1 ist innerhalb eines insbesondere monolithisch integrierten Schaltkreises 2 angeordnet. Die Schaltung 1 weist eine Betriebsspannungsleitung 3, eine zu schützende interne Schaltungsanordnung 4, eine Masse-Anschlußleitung 5 und als Verpolungs-Schutzeinrichtung einen Transistor 6 auf. Die Betriebsspannungsleitung 3 ist mit einem Eingang 7 der internen Schaltungsanordnung 4 verbunden. Ein Ausgang 8 der internen Schaltungsanordnung 4 ist über den Transistor 6 mit der Masse-Anschlußleitung 5 verbunden. Der Transistor 6 weist eine Source-Elektrode 9, eine Drain-Elektrode 10 und eine Gate-Elektrode 11 auf. Die Source-Elektrode 9 ist über die Masse-Anschlußleitung 5 mit dem Anschluß für eine externe Masse 12 verbunden. Die Drain-Elektrode 10 ist über die Leitung 5' mit dem Anschluß 8 für die 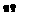 innere" Masse der interen Schaltungsanordnung 4 verbunden. Die Gate-Elektrode 11 ist mit der internen Schaltungsanordnung 4 verkoppelt und hat als Ansteuerpotential im Normalbetrieb zum Beispiel die positive Betriebsspannung Vdd.

Im Ausführungsbeispiel von Fig. 1 ist ferner entsprechend der Weiterbildung der Erfindung, die mindestens einen Signalausgang 150 des Schaltkreises 2 betrifft, die Drain-Elektrode 10 des Transistors 6 über eine Leitung 13 mit einem Source-Anschluß 14 eines Transistors 15 verbunden, der einen Open-Drain-Ausgang 151 aufweist und dessen Gate-Elektrode mit einem Signalausgang 152 der Schaltung 1 verbunden ist. Wenn die Schaltung weitere Signalausgänge aufweist, dann können diese Ausgänge in gleicher Weise gegen die zerstörenden Wirkungen der Betriebsspannungsverpolung geschützt werden.

Bei dem in Fig. 2 gezeigten Tranistor 6 in Schnittbilddarstellung handelt es sich um einen n-Kanal-MOSFET vom Enhancement-Typ der beispielsweise zur Verwendung in der Schaltungsanordnung nach Fig. 1 geeignet ist. In der Schnittbilddarstellung ist unterhalb der Source-Elektrode 9, die mit der Masse-Anschlußleitung 5 zu verbinden ist, ein n+ - dotiertes Source-Gebiet 16 dargestellt. Die Angabe 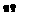 unterhalb" bezieht sich in der Beschreibung auf die Angabe der vertikalen Zuordnung der verschiedenen Halbleitergebiete in der üblichen Schnittbilddarstellung, und bedeuted in der Regel, daß das obere Gebiet in das untere Gebiet lateral und vertikal eingebettet ist. Unterhalb der Drain-Elektrode 10, die mit der Masse-Anschlußleitung 5' zu verbinden ist, ist ein n+-dotiertes Drain-Gebiet 17 angeordnet. Zwischen der Source-Elektrode 9 und der Drain-Elektrode 10 befindet sich isoliert die Gate-Elektrode 11. Zur Isolation ist zwischen der Gate-Elektrode 11 und dem Source-Gebiet 16 eine Feldoxidschicht 18 angeordnet. Das n-leitende Source-Gebiet 16 und die Feldoxidschicht 18 liegen nebeneinander innerhalb einer n--dotierten Wanne 19, die in einem p--Substrat 20 angeordnet. Im normalen Betriebsfall ist die resultierende Sperrschicht zwischen der Wanne 19 und dem Substrat 20 gesperrt, wodurch das Source-Gebiet 16 vom Substrat 20 isoliert ist.

Im Normalbetrieb ist die positive Betriebsspannung Vdd oder ein Teil der positiven Betriebsspannung über die interne Schaltungsanordnung 4 mit der Gate-Elektrode 11 gekoppelt. Der n-Kanal-Transistor 6 ist dadurch leitend und schaltet durch, so daß über die mit dem Anschluß 12 für die externen Masse verbundene Source-Elektrode 9 und Drain-Source-Strecke des Transistors 6 auch der Anschluß 8 der inneren Schaltungsanordnung 4 im wesentlichen auf Masse liegt.

Kommt es nun zu einer Verpolung der Anschlüsse, so daß an der Betriebsspannungsleitung 3 Masse und am Anschluß 12 der externen Masse die positive Betriebsspannung Vdd anliegt, so wird beim Transistor 6 die Source-Elektrode 9 zu einer Drain-Elektrode und die Drain-Elektrode 10 zu einer Source-Elektrode. Die der Wanne 19 zugeordnete Elektrode 9 stellt also im Verpolungsfall nunmehr die Drain-Elektrode dar. An der Gate-Elektrode 11 liegt nun wie an der Betriebsspannungsleitung 3 ebenfalls Masse an, so daß der n-Kanal-Transistor 6 sperrt. Damit ist der Anschluß 8 der Schaltungsanordnung 4 von der verpolten und eventuell auch noch zu hohen Betriebsspannung Vdd getrennt und es kann nicht zur Zerstörung der inneren Schaltungsanordnung 4 kommen. Die Betriebsspannung fällt somit über die Drain-Sourc-Strecke 12, 10 des Transistors 6 ab. Damit Tranistor 6 nun nicht selbst durch die anliegende und gegebenenfalls zu hohe Betriebsspannung zerstört wird, ist für das n+-Gebiet 16 die bereits beschriebene schwach dotierte n--Wanne 19 vorgesehen, in der sich gegebenenfalls eine zu große Feldstärke zwischen der Elektrode 9 und dem Massepotential an der Gate-Elektrode 11 im Verpolungsfall abbauen kann.

Der Schutz des mindestens einen Ausgangstransistors 15, dessen Gate-Elektrode 153 von einem innenliegenden Signalausgang 152 gesteuert ist, erfolgt durch den in Fig.1 dargestellten Transistor 6. Die Source-Elektrode 14 des beispielsweise in einer Offenen-Drain-Schaltung (=open-drain) betriebenen Transistors 15 wird durch den Transistor 6 von der verpolten Spannung am Anschluß 12 getrennt und weist somit nur Spannungen im Bereich des Massepotentials auf. Der Transistor 15 ist damit gegen die Betriebspannungsverpolung und die dabei gegebenenfalls vorhandenen Überspannungen geschützt.

Eine weitere Ausführungsform zum Schutz des Signalausgangstransistors 15 besteht darin, daß dieser Transistor 15 im wesentlichen wie Transistor 6 - vergleiche beispielsweise die Schnittbilddarstellung Fig. 2 - ausgeführt ist. Für diese Ausführungsvariante ist der Source-Anschluß 14 dieses Transistors 15 nicht mehr mit dem Drain-Anschluß 10 des Transistors 6 verbunden, sondern direkt mit dem Anschluß 12 für die Masse - die Anschlußangaben beziehen sich hierbei auf den unverpolten Betriebsfall. In dem Schaltungsbeispiel von Fig. 1 ist diese Schaltungsart mittels einer gestrichelt dargestellten Source-Masse-Anschlußleitung 13' für den Transistor 15 angedeutet. Die Schutzwirkung des Transistor 6 ist damit zum Schutz des Ausgangstransistors 15 nicht mehr erforderlich, aber natürlich nach wie vor für die innere Schaltung 4. Für den Ausgangstransistor 15 kann auch wie beim Transistor 6 ein DMOS-Transistor verwendet werden, der im Verpolungsfall auch einer hohen Verpolungsspannung widerstehen kann.

### Bezugszeichenliste

- 1: Schaltung
- 2: Schaltkreis
- 3: Betriebsspannungsleitung
- 4: (interne/innere) Schaltungsanordnung
- 5: Masse-Anschlußleitung
- 5': (Teil der) Masse-Anschlußleitung
- 6: Transistor
- 7: Eingang (Anschluß für positive Betriebsspannung)
- 8: Ausgang (Anschluß für innere Masse)
- 9: Source-Elektrode
- 10: Drain-Elektrode
- 11: Gate-Elektrode
- 12: (Anschluß für externe) Masse
- 13: Leitung
- 13': Source-Masse-Anschlußleitung
- 14: Source-Anschluß
- 15: (Signalausgangs-) Transistor
- 16: Source-Gebiet
- 17: Drain-Gebiet
- 18: Feldoxidschicht
- 19: (n-dotierte/leitende) Wanne
- 20: (p-leitendes) Substrat
- 150: Ausgangsanschluß
- 151: Open-Drain-Elektrode
- 152: Signalausgang
- 153: Gate-Elektrode
- Vdd: Betriebsspannung

## Patentansprüche

1. Schaltung
mit einer Betriebsspannungsleitung (3), einer Masse-Anschlußleitung (5) und einer Verpolschutzeinrichtung,
**dadurch gekennzeichnet**,
daß als Verpolschutzeinrichtung in die Masse-Anschlußleitung (5), die auf einem Schaltkreis (2) eine Masseverbindung zu einer inneren Schaltungsanordnung (4) herstellt, ein Transitor (6) eingefügt ist,
welcher im Normalbetrieb, der durch Anliegen der Betriebsspannung (Vdd) an der Betriebsspannungsleitung (3) und durch Anliegen der Masse an der Masse-Anschlußleitung (5) definiert ist, in einen leitenden Zustand geschaltet ist und
welcher im Verpolungsfall, der durch Anliegen der Betriebsspannung (Vdd) an der Masse-Anschlußleitung (5) und durch Anliegen der Masse an der Betriebsspannungsleitung (3) definiert ist, in einen nichtleitenden Zustand geschaltet ist,
wobei der Transistor (6) geeignet ist, im Verpolungsfall eine hohe Betriebsspannung aufzunehmen.

2. Schaltung nach dem vorhergehenden Anspruch,
dadurch gekennzeichnet,
daß der Transistor (6) ein MOS-Feldeffektransistor mit Drain, Source und Gate ist, dessen Source-Gebiet (16) mit zugehöriger Source-Elektrode (9) in eine Wanne (19) eingebettet ist, wobei die Wanne (19) vom gleichen Leitfähigkeitstyp wie der Transistor (6), jedoch vom entgegengesetzten Leitfähigkeitstyp zu dessen Substrat (20) ist und die Definition des Source-Gebietes (16) und der Source-Elektrode (9) sich auf den Normalbetrieb bezieht.

3. Schaltung nach einem der vorhergehenden Ansprüche,
dadurch gekennzeichnet,
daß die Steuer-Elektrode (11) des Transistors (6) mit der Betriebsspannungsleitung (3) verkoppelt ist.

4. Schaltung nach einem der vorhergehenden Ansprüche,
dadurch gekennzeichnet,
daß das Substrat (20) im Normalbetrieb mit einer Drain-Elektrode (10) verkoppelt ist.

5. Schaltung nach einem der vorhergehenden Ansprüche,
dadurch gekennzeichnet,
daß der Transistor (6) ein MOS-Feldeffekttransistor, insbesondere ein n-Kanal-Transistor, vom Enhancement-Typ ist.

6. Schaltung nach einem der vorhergehenden Ansprüche,
dadurch gekennzeichnet,
daß die Wanne (19) im Vergleich zum Source- oder Drain-Gebiet (16 bzw. 17) relativ schwach dotiert ist, z.B. n--dotiert.

7. Schaltung nach einem der vorhergehenden Ansprüche,
dadurch gekennzeichnet,
daß als zusätzlicher Verpolungsschutz in die Betriebsspannungsleitung (3) ein p-Kanal-MOS-Feldeffekttransistor eingefügt ist.

8. Schaltung nach einem der Ansprüche 1 bis 7,
dadurch gekennzeichnet,
daß die Source-Elektrode (14) eines als Ausgangstransistor dienenden Transistors (15) mit der Drain-Elektrode (10) des Transistors (6) verbunden ist, wobei die Elektroden- und Anschlußbezeichnungen auf den Normalbetrieb bezogen sind.

9. Schaltung nach einem der Ansprüche 1 bis 7,
dadurch gekennzeichnet,
daß die Source-Elektrode (14) eines als Ausgangstransistor dienenden Transistors (15) direkt mit dem Anschluß (12) für Masse verbunden ist, wobei die Elektroden- und Anschlußbezeichnungen auf den Normalbetrieb bezogen sind.

10. Schaltung nach Anspruch 9,
dadurch gekennzeichnet,
daß der Transistor (15) im wesentlichen gleich dem Transistor (6) ausgebildet ist, um im Verpolungsfall zu sperren und eine Überspannung zwischen der Drain-Source-Strecke aufzunehmen.
